(19) **Europäisches Patentamt**

**European Patent Office**

**Office européen des brevets**

(11) **EP 1 137 187 A2**

(12) **EUROPEAN PATENT APPLICATION**

(43) Date of publication:
26.09.2001 Bulletin 2001/39

(51) Int Cl.7: **H03L 7/08**

(21) Application number: **00310711.7**

(22) Date of filing: **01.12.2000**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **03.12.1999 US 168903 P**

(71) Applicant: **Texas Instruments Incorporated**
**Dallas, Texas 75251 (US)**

(72) Inventors:
• **Spagna, Fulvio**
  **San José, California 95124 (US)**
• **Fukahori, Kiyoshi**
  **Mountain View, California 94043 (US)**

(74) Representative: **Potter, Julian Mark**
**D. Young & Co.,**
**21 New Fetter Lane**
**London EC4A 1DA (GB)**

(54) **Phase locked loop**

(57)    A phase locked loop circuit for eliminating loop latency includes an input circuit for inputting a phase signal corresponding to phase changes and an actual phase signal corresponding to actual phase sampling of a sampling clock, a filter circuit for connecting the phase signal and the actual phase signal to a phase update signal, and a feedback circuit to eliminate the loop latency by feeding back to the filter circuit a portion of the phase update signal.

FIG. 4

EP 1 137 187 A2

**Description**

The present invention relates to phase locked loop topology including and, more particularly, but not exclusively, the phase locked loop technology for compensating for the effects of loop latency in a read channel.

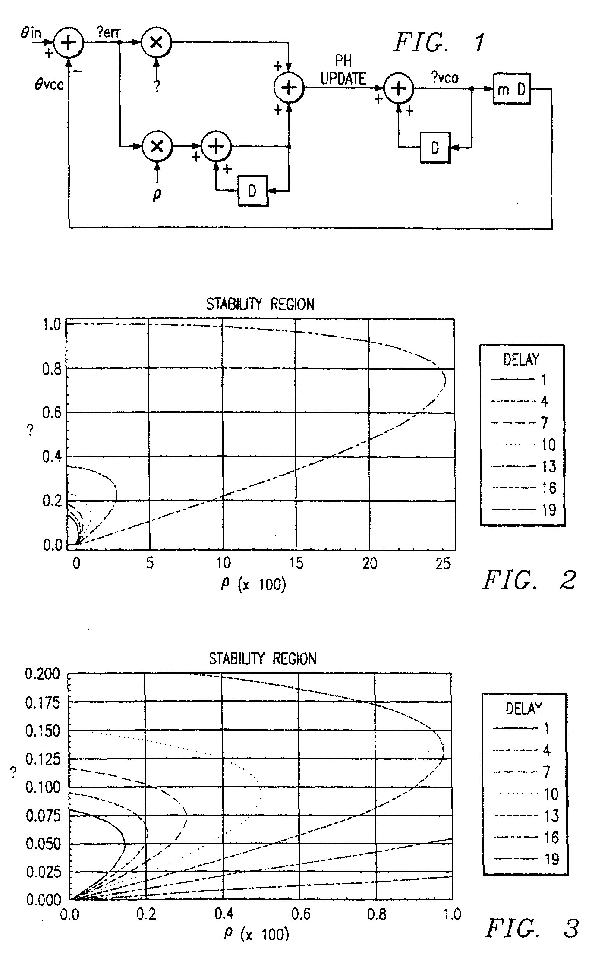

The design of phase locked loops for hard disk drives (HDD) data recovery has been used by implementing decision directed algorithms to adjust the frequency and phase of the recovered clock in order to optimize the sampling instants (timing instants) of the received signals. These algorithms which, by their very nature, depend on a reliable estimate (decision) of the current sample, have grown in complexity as the read channel signal processing has moved to higher partial response polynomials. One way of obtaining reliable phase error estimates relies on obtaining decision (binning) information from the Viterbi detector. Because of the complexity associated with this block, these topologies are characterized by latencies, usually symbolized by the term mD, which can be easily in excess of 20 clock cycles. Figure 1 illustrates one such circuit.

The excessive latency greatly reduces the region in which the PLL is stable. As an example, Figures 2 and 3 show how one such region varies as the latency increases from one clock cycle (ideal) to 19 clock cycles (representative of a medium latency digital PLL). In practical terms, besides an increase in the complexity of the system model, the larger the latency, relative to the time scale of the dynamics of the process, the loop gain reduction needs to be larger. Under most circumstances, this causes poor performance and sluggish response within the PLL.

Loop latency also has a significant impact on the design of the time base generator, which is a circuit that generates the reference clock for the PLL.

Thus, there has been a need for topology which decouples the clock recovery circuit performance from the loop latency while maintaining reliability in the phase detection process.

Viewed from a first aspect, the present invention provides a circuit that eliminates or at least reduces the latency associated with external delays. A feedback loop is provided to eliminate or reduce these delays. An embodiment of the present invention provides a substantially zero steady state error in the presence of offsets between the frequency of the input signal and the frequency of the reference clock.

Embodiments of the invention will now be described, by way of example only, and with reference to the following drawings, in which:

Figure 1 illustrates a PLL circuit;
Figure 2 illustrates a stability region as a function of latency;
Figure 3 illustrates another stability region as a function of latency;
Figure 4 illustrates a circuit diagram of an embodiment of the present invention;
Figure 5 illustrates another circuit diagram of an embodiment of the present invention;
Figure 6 illustrates another circuit diagram of an embodiment of the present invention;
Figure 7 illustrates another circuit diagram of an embodiment of the present invention;
Figure 8 illustrates another circuit diagram of an embodiment of the present invention;
Figure 9 illustrates another circuit diagram of an embodiment of the present invention;
Figure 10 illustrates another circuit diagram of an embodiment of the present invention;
Figure 11 illustrates another circuit diagram of an embodiment of the present invention;
Figure 12 illustrates a stability region as a function of latency;
Figure 13 shows another stability region as a function of latency;
Figure 14 shows another stability region as a function of latency;
Figure 15 shows comparisons of the system dynamics in response to a phase step;
Figure 16 shows comparisons of the system dynamics in response to a frequency step;
Figure 17 shows comparisons of the system dynamics in response to a frequency ramp;
Figure 18 shows graphs of embodiments of the present invention;
Figure 19 is a side view of a disk drive system; and
Figure 20 is a top view of a disk drive system.

Embodiments of the following invention are described with reference to Figures in which similar or the same numbers represent the same or similar elements. While embodiments of the invention are described in terms for achieving various objectives, it can be appreciated by those skilled in the art that variations may be accomplished in view of these teachings without deviation from the spirit or scope of the invention.

Figures 19 and 20 show a side and top view, respectively, of the disk drive system designated by the general reference 100 within an enclosure 110. The disk drive system 100 includes a plurality of stacked magnetic recording disks 112 mounted to a spindle 114. The disks 112 may be conventional particulate or thin film recording disk or, in other embodiments, they may be liquid-bearing disks. The spindle 114 is attached to a spindle motor 116 which rotates the spindle 114 and disks 112. A chassis 120 is connected to the enclosure 110, providing stable mechanical support for the disk drive system. The spindle motor 116 and the actuator shaft 130 are attached to the chassis 120. A hub assembly 132 rotates about the actuator shaft 130 and supports a plurality of actuator arms 134. The stack of actuator arms 134 is sometimes referred to as a "comb." A rotary voice coil motor 140 is attached to chassis 120 and to a rear portion of the actuator arms 134.

A plurality of head suspension assemblies 150 are attached to the actuator arms 134. A plurality of inductive transducer heads 152 are attached respectively to the suspension assemblies 150, each head 152 including at least one inductive write element. In addition thereto, each head 152 may also include an inductive read element or a MR (magneto-resistive) read element. The heads 152 are positioned proximate to the disks 112 by the suspension assemblies 150 so that during operation, the heads are in electromagnetic communication with the disks 112. The rotary voice coil motor 140 rotates the actuator arms 134 about the actuator shaft 130 in order to move the head suspension assemblies 150 to the desired radial position on disks 112.

A controller unit 160 provides overall control to the disk drive system 100, including rotation control of the disks 112 and position control of the heads 152. The controller unit 160 typically includes (not shown) a central processing unit (CPU), a memory unit and other digital circuitry, although it should be apparent that these aspects could also be enabled as hardware logic by one skilled in the computer arts. Controller unit 160 is connected to the actuator control/drive unit 166 which is in turn connected to the rotary voice coil motor 140. A host system 180, typically a computer system or personal computer (PC), is connected to the controller unit 160. The host system 180 may send digital data to the controller unit 160 to be stored on the disks, or it may request that digital data at a specified location be read from the disks 112 and sent back to the host system 180. A read/write channel 190 is coupled to receive and condition read and write signals generated by the controller unit 160 and communicate them to an arm electronics (AE) unit shown generally at 192 through a cut-away portion of the voice coil motor 140. The AE unit 192 includes a printed circuit board 193, or a flexible carrier, mounted on the actuator arms 134 or in close proximity thereto, and an AE module 194 mounted on the printed circuit board 193 or carrier that comprises circuitry preferably implemented in an integrated circuit (IC) chip including read drivers, write drivers, and associated control circuitry. The AE module 194 is coupled via connections in the printed circuit board to the read/write channel 190 and also to each read head and each write head in the plurality of heads 152. The read/write channel 190 includes the PLL circuit of the present invention.

An embodiment of the present invention cancels the effects that latency has on the timing loop of a PLL circuit and is based upon the concept that every time the PLL Vco phase is updated, it obeys the following equation (Figure 1):

$$\varphi vco_n = \varphi vco_{n-1} + pbUpdate_{n-1} \tag{1}$$

On the other side, by definition of the phase error, Equation (2) follows.

$$\varphi err_n = \theta in_{n-1} - \theta vco_{n-1} = \theta in_{n-1} - \varphi vco_{n-m-1} \tag{2}$$

One can compute exactly the amount by which the phase error would have to be reduced as a consequence of the update in the Vco phase. One way to eliminate the effects of latency is to remove the correction for latency from the next phase error term. This can be done by feeding back the Vco phase information and subtracting it from the phase error. We will call the results of this operation the delay compensated phase error which is defined by Equation (3).

$$\lambda_n = \varphi err_{n-1} - \varphi vco_{n-1} = \theta in_{n-2} - \varphi vco_{n-m-2} - \varphi vco_{n-1} \tag{3}$$

and has three distinct components as illustrated in Equation (3a).

$$\theta in_{n-1} \quad , \qquad \text{input related phase changes}$$

$$\varphi vco_{n-m-1} , \qquad \text{delayed vco phase term} \tag{3a}$$

$$\varphi vco_{n-1} \qquad \text{delay compensation term}$$

Equation (3) implies that the PLL loop would process the same correction twice, once at time index n-1 and once at time index n-m-2. Since this is not desirable, it is more desirable to eliminate the $\varphi vco_{n-m-2}$ term. This operation can be accomplished by redifining $\lambda$ as illustrated in Equation (4).

$$\lambda_n = \varphi err_{n-1} - \psi_{n-1} = (\theta in_{n-2} - \theta vco_{n-2}) - (\varphi vco_{n-2} - \varphi vco_{n-m-2}) = \theta in_{n-2} - \varphi vco_{n-2} \tag{4}$$

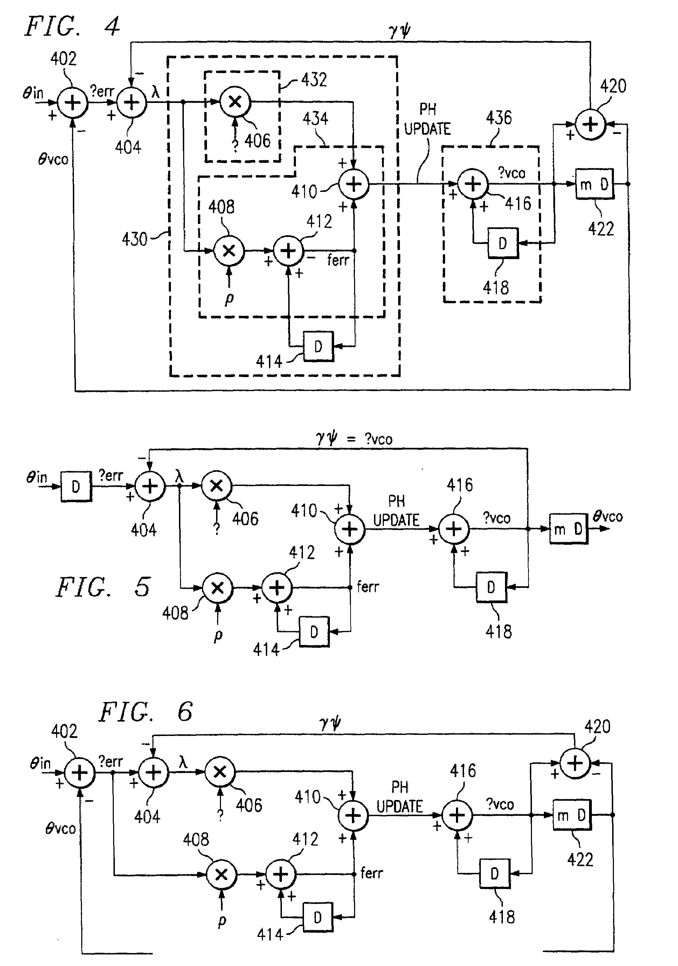

The implementation of this concept is shown in Figure 4. $\theta_n$ is input to adder circuit 402. Additionally, $\theta vco$ is input to the negative input of adder circuit 402. The output signal $\phi$ of adder circuit 402 is input to adder circuit 404. In addition, signal $\gamma\psi$ is input to adder circuit 404. Output from adder circuit 404 is the signal $\lambda$ which is input both to multiplier 406 and multiplier 408. The multiplier 406 amplifies $\lambda$ by $\alpha$ and is output to adder circuit 410. The multiplier circuit 408 multiplies $\lambda$ by $\rho$ and outputs $\rho\lambda$ to the adder circuit 412. The output of adder circuit 412 is delayed by delay circuit 414 and input to adder circuit 412. The output of adder circuit 412 is additionally input to adder circuit 410. The output of adder circuit 410 is signal $phUpdate_{n-1}$ and input to adder circuit 416. The output of adder circuit 416 is $\varphi vco$ which is input to delay circuit 418. The output of delay circuit 418 is input to adder circuit 416. The output of adder circuit 416 $\varphi vco$ is input both to adder circuit 420 and delay circuit 422. The delay circuit 422 represents the delay associated with the sampling (A/D), equalization (FIR) and phase detector circuits. The output of delay circuit 422 is input to adder circuit 420 and also as $\theta vco$ to adder circuit 402. The output of adder circuit 420 $\gamma\psi$ is input to adder circuit 404.

The proportional branch 432 includes multiplier 406, and the integral branch 434 includes multiplier 408, adder 412 and delay 414. Adder 412 in conjunction with delay 414 is also an integral accumulator. The Vco accumulator 436 includes adder 416 and delay 418. The Pll filter 430 includes the porportional branch 432 and the integral branch 434.

This topology accomplishes the stated advantage of making the performance of the overall timing loop strongly decoupled from m, depending solely on the delay associated with the loop filter, the Vco accumulator and the delay compensation loop. With reference to Figure 4, we can write the delay compensated phase error signal $\lambda_n$ in Equation (5).

$$\lambda_n = \varphi err_{n-1} - \gamma \psi_{n-1} = (\theta in_{n-2} - \theta vco_{n-2}) - \gamma (\varphi vco_{n-2} - \theta vco_{n-2}) = (\theta in_{n-2} - \gamma \varphi vco_{n-2}) - (\theta vco_{n-2} - \gamma \theta vco_{n-2}) \tag{5}$$

Here, $\varphi_{err}$ is the phase error, $\psi_n$ is the delay compensation feedback. The delay compensation gain $\gamma$ is a parameter which allows to turn on and turn off the effects of the delay compensating network. Since $\theta vco$ is the delayed version of $\varphi vco$, we can write Equation (6):

$$\theta vco_n = \varphi vco_{n-m} \tag{6}$$

where m is the portion of the overall loop latency due to the sampling network (e.g. AID), equalization circuits (e.g. FIR) and phase detector (inclusive of Viterbi processing latency) of the read channel 190. $\theta vco$ is the phase of the sampling clock. The fundamental Vco update equation is shown in Equation (7):

$$\varphi vco_n = \varphi vco_{n-1} + \text{phUpdate}_{n-1} \tag{7}$$

Combining (6) and (7) leads to Equation (8):

$$\theta vco_n = \theta vco_{n-1} + \text{phUpdate}_{n-m-1} \tag{8}$$

For a traditional PI filter, we have Equation (9):

$$\text{phUpdate}_n = \alpha \, \lambda_{n-2} + \rho \sum_{j=1}^{n-3} \lambda_j \tag{9}$$

Combining (8) and (9) yields Equation (10):

$$\theta vco_n - 2\,\theta vco_{n-1} + \theta vco_{n-2} = \alpha \, (\lambda_{n-m-3} - \lambda_{n-m-4}) + \rho \, \lambda_{n-m-4} \tag{10}$$

and substituting (5) into (10) yields Equation (11):

$$
\begin{aligned}
\theta vco_n - 2\,\theta vco_{n-1} + \theta vco_{n-2} = {}& \\
\alpha \, ((\theta in_{n-m-5} - \gamma \, \varphi vco_{n-m-5}) - (\theta vco_{n-m-5} - \gamma \, \theta vco_{n-m-5}) - {}& \\
(\theta in_{n-m-6} - \gamma \, \varphi vco_{n-m-6}) + (\theta vco_{n-m-6} - \gamma \, \theta vco_{n-m-6})) + {}& \\
\rho \, ((\theta in_{n-m-6} - \gamma \, \varphi vco_{n-m-6}) - (\theta vco_{n-m-6} - \gamma \, \theta vco_{n-m-6}))&
\end{aligned}
\tag{11}
$$

This provides a baseline for comparison with embodiments of the present invention. We discuss the uncompensated case for which $\gamma = 0$.

Open Loop Gain

From Equations (5) and (10) we obtain Equation (12):

$$\theta vco_n - 2\,\theta vco_{n-1} + \theta vco_{n-2} = \alpha \, (\varphi err_{n-m-4} - \varphi err_{n-m-5}) + \rho \, \varphi err_{n-m-5} \tag{12}$$

Taking the z-transform of (12), we obtain an open loop transfer function in Equation (13):

$$OlGain_0 = z^{-m} \frac{\alpha (z^{-5} - z^{-6}) + \rho z^{-6}}{1 - 2 z^{-1} + z^{-2}} = \frac{z^{-4-m} ((-1 + z) \alpha + \rho)}{(-1 + z)^2}$$

$$(13)$$

As expected, the open loop transfer functions contain a $z^{-m}$ factor associated with loop latency.

**Closed Loop Gain**

The closed loop transfer function can be obtained directly from Equation (11) which, for $\gamma = 0$, simplifies to Equation (14):

$$\Theta vco_n - 2 \Theta vco_{n-1} + \Theta vco_{n-2} =$$
$$\alpha ((\Theta in_{n-m-5} - \Theta vco_{n-m-5}) - (\Theta in_{n-m-6} - \Theta vco_{n-m-6})) + \rho (\Theta in_{n-m-6} - \Theta vco_{n-m-6})$$

$$(14)$$

Equation (14) can be manipulated to yield Equation (15):

$$\Theta vco_n - 2 \Theta vco_{n-1} + \Theta vco_{n-2} + \alpha (\Theta vco_{n-m-5} - \Theta vco_{n-m-6}) + \rho \Theta vco_{n-m-6} =$$
$$\alpha (\Theta in_{n-m-5} - \Theta in_{n-m-6}) + \rho \Theta in_{n-m-6}$$

$$(15)$$

Taking the z-transform of (15), the following closed loop transfer function in Equation (16) is obtained:

$$ClGain_0 = z^{-m} \frac{\alpha (z^{-5} - z^{-6}) + \rho z^{-6}}{1 - 2 z^{-1} + z^{-2} + z^{-m} (\alpha (z^{-5} - z^{-6}) + \rho z^{-6})} =$$
$$\frac{(-1 + z) \alpha + \rho}{(-1 + z) \alpha + \rho + (-1 + z)^2 z^{4+m}}$$

$$(16)$$

This equation clearly indicates the transfer function dependency on the loop latency m. In particular, the stability of the system, i.e. the locations of the closed loop poles, depends on m.
***The compensated system,*** $\gamma = 1$ ***is now discussed.***

**Closed Loop Gain**

The derivation of the closed loop transfer function is discussed. In this case, since $\gamma = 1$, Equation (11) simplifies to Equation (17):

$$\Theta vco_n - 2 \Theta vco_{n-1} + \Theta vco_{n-2} =$$
$$\alpha ((\Theta in_{n-m-5} - \varphi vco_{n-m-5}) - (\Theta in_{n-m-6} - \varphi vco_{n-m-6})) +$$
$$\rho (\Theta in_{n-m-6} - \varphi vco_{n-m-6})$$

$$(17)$$

which, recalling Equation (6) can be manipulated to yield Equation (18):

$$\theta vco_n - 2\,\theta vco_{n-1} + \theta vco_{n-2} + \alpha\,(\theta vco_{n-5} - \theta vco_{n-6}) + \rho\,\theta vco_{n-6} = \\ \alpha\,(\theta in_{n-m-5} - \theta in_{n-m-6}) + \rho\,\theta in_{n-m-6} \tag{18}$$

Taking the z-transform of Equation (18), we can obtain the following closed loop transfer function, expressed by Equation (19):

$$ClGain_1 = \\ z^{-m}\,\frac{\alpha\,(z^{-5} - z^{-6}) + \rho\,z^{-6}}{1 - 2\,z^{-1} + z^{-2} + \alpha\,(z^{-5} - z^{-6}) + \rho\,z^{-6}} = z^{-m}\,\frac{(-1+z)\,\alpha + \rho}{(-1+z)^2\,z^4 + \alpha\,(-1+z) + \rho} \tag{19}$$

Note that the term $z^{-m}$ can be factored out indicating that, apart from a delay term, the closed loop transfer function is equivalent to Equation (20):

$$\frac{(-1+z)\,\alpha + \rho}{(-1+z)^2\,z^4 + \alpha\,(-1+z) + \rho} \tag{20}$$

Consequently, the equation is not dependent on loop latency m, but is only dependent on the latency of the inner loop, which is essentially the latency of the loop filter 432 and the Vco accumulator 436. In other words, the circuit of Figure 4 is mathematically equivalent to the circuit of Figure 5, and all stability considerations should be concerned solely with Equation (20). In Figure 5, the output of adder 416 is connected directly to adder 404.

**Open Loop Gain**

The open loop transfer function can be computed directly from Equation (10) which, considering (5) and (6) can be rewritten as Equation (21):

$$\varphi vco_{n-m} - 2\,\varphi vco_{n-m-1} + \varphi vco_{n-m-2} = \alpha\,(\,\theta in_{n-m-5} - \theta in_{n-m-6}) + \rho\theta in_{n-m-6} \tag{21}$$

The z transform, Equation (22), is obtained as follows:

$$OlGain_1 = \frac{\alpha\,(z^{-5} - z^{-6}) + \rho z^{-6}}{1 - 2z^{-1} + z^{-2}} = \frac{(-1+z)\,\alpha + \rho}{(-1+z)^2\,z^4} \tag{22}$$

which differs from Equation (13) because the delay term $z^{-m}$ (the loop latency) is now absent.

**Steady state error**

The steady state errors to some common inputs, for example the steady state error to a phase step $\eta$, is given by Equation (23):

$$\lim_{z \to 1} \left( (z - 1) \left( \frac{\eta \, z}{z - 1} \right) \left( 1 - z^{-m} \frac{(-1 + z) \, \alpha + \rho}{(-1 + z) \, ((-1 + z) \, z^4 + \alpha) + \rho} \right) \right) = 0 \tag{23}$$

The steady state error to a frequency step $w_0$ is given by Equation (24):

$$\lim_{z \to 1} \left( (z - 1) \left( \frac{w_0 \, z}{(z - 1)^2} \right) \left( 1 - z^{-m} \frac{(-1 + z) \, \alpha + \rho}{(-1 + z) \, ((-1 + z) \, z^4 + \alpha) + \rho} \right) \right) = m \, w_0 \tag{24}$$

Equation (24) leads us to a limitation of the present scheme, as shown in Figure 4, that the steady state error due to a frequency step is non-zero and depends on the latency of the loop m. The reason becomes apparent when Equation (5) is rewritten for $\gamma = 1$ and uses the relationship between $\theta vco$ and $\varphi vco$ shown in Equation (6) to obtain Equation (25):

$$\lambda_{n-m} = (\theta in_{n-m-2} - \varphi vco_{n-m-2}) = (\theta in_{n-m-2} - \theta vco_{n-2}) \tag{25}$$

Since $\lambda$ plays the role of system error signal, Equation (25) indicates that the feedback loop as shown in Figure 5 is aligning the current phase of the Vco to the phase of the input signal m clock cycles earlier. Equation (24) is then the result.

Although the scheme of Figure 4 is a solution to our stated problem in the presence of a phase step input, improvement can be achieved in practical cases where uncertainties in the frequency of the input signal make that assumption unnecessarily restrictive.

If we expand the eterm 1-CIGain in Equation (24), we obtain Equation (26):

$$\frac{(-1 + z)^2 \, z^4 + \alpha \, (-1 + z) + \rho - z^{-m} \, ((-1 + z) \, \alpha + \rho)}{(-1 + z) \, ((-1 + z) \, z^4 + \alpha) + \rho} = \frac{(-1 + z)^2 \, z^4 + \alpha \, (-1 + z) \, (1 - z^{-m}) + \rho \, (1 - z^{-m})}{(-1 + z) \, ((-1 + z) \, z^4 + \alpha) + \rho} \tag{26}$$

It is noted that the numerator of Equation (26) has to go to zero faster than (z-1) for the limit in Equation (24) to yield zero. For this to happen, the coefficient of the integral gain $\rho$ in the numerator must be either 0 or contain a (z-1) term. When either condition is met, the system should be able to track a frequency step with zero steady state error.

Next, two examples will be illustrated, starting from the topology of Figure 4, evolving to a configuration capable of processing uncertainties in the frequency of the input signal. As illustrated in Figure 6, and rewriting Equation (10), Equation (27) is achieved.

$$\theta vco_n - 2 \, \theta vco_{n-1} + \theta vco_{n-2} = \alpha \, (\lambda_{n-m-3} - \lambda_{n-m-4}) + \rho \, \varphi err_{n-m-5} \tag{27}$$

Equation (27) reflects the fact that the integral path is being driven by $\varphi err$ (scheme A).

Next, the open loop gain is illustrated.

**Open Loop Gain**

From Equation (27) we obtain Equation (27a) expressing $\lambda$ in terms of $\varphi err$ :

$$\theta vco_n - 2\theta vco_{n-1} + \theta vco_{n-2} =$$

$$\alpha(\varphi err_{n-m-4} - \psi_{n-m-4} - \varphi err_{n-m-5} + \psi_{n-m-5}) + \rho \, \varphi err_{n-m-5} =$$

$$\alpha(\varphi err_{n-m-4} - \varphi err_{n-m-5}) +$$

$$\rho\varphi err_{n\text{-}m\text{-}5} - \alpha(\varphi vco_{n\text{-}m\text{-}5} - \theta vco_{n\text{-}m\text{-}5} - \varphi vco_{n\text{-}m\text{-}6} + \theta vco_{n\text{-}m\text{-}6}) =$$

$$\alpha(\varphi err_{n\text{-}m\text{-}4} - \varphi err_{n\text{-}m\text{-}5}) + \rho\varphi err_{n\text{-}m\text{-}5} -$$

$$\alpha(\theta vco_{n\text{-}5} - \theta vco_{n\text{-}m\text{-}5} - \theta vco_{n\text{-}6} + \theta vco_{n\text{-}m\text{-}6}) \tag{27a}$$

Equation (27a) yields the open loop transfer function in the z-domain, expressed as Equation (28):

$$OlGain_2 := z^{-m} \frac{\alpha (z^{-5} - z^{-6}) + \rho z^{-6}}{1 - 2z^{-1} + z^{-2} + \alpha(z^{-5} - z^{-6}) - \alpha(z^{-m-5} - z^{-m-6})} = \frac{(-1 + z)\alpha + \rho}{(-1 + z)(-\alpha + z^m((-1 + z)z^4 + \alpha))} \tag{28}$$

**Closed Loop Gain**

Equation (27) in view of Equation (11) is transformed to Equation (29):

$$\theta vco_n - 2\theta vco_{n-1} + \theta vco_{n-2} =$$
$$\alpha ((\theta in_{n-m-5} - \varphi vco_{n-m-5}) - (\theta in_{n-m-6} - \varphi vco_{n-m-6})) +$$
$$\rho (\theta in_{n-m-6} - \theta vco_{n-m-6}) =$$
$$\alpha ((\theta in_{n-m-5} - \theta vco_{n-5}) - (\theta in_{n-m-6} - \theta vco_{n-6})) + \rho (\theta in_{n-m-6} - \theta vco_{n-m-6}) \tag{29}$$

The closed loop transfer function in the z-domain is illustrated in Equation (30).

$$ClGain_{20} := z^{-m} \frac{\alpha (z^{-5} - z^{-6}) + \rho z^{-6}}{1 - 2z^{-1} + z^{-2} + \alpha(z^{-5} - z^{-6}) + \rho z^{-m-6}} = \frac{(-1 + z)\alpha + \rho}{(-1 + z)z^m(-1 + z)z^4 + \alpha) + \rho} \tag{30}$$

If we compare Equation (30) to the one obtained for the topology of Figure 4, Equation (19), the term $z^{-m}$ can no longer be factored out. The consequence of this is that the loop latency will be only partially compensated, but the system will deal with the frequency uncertainties as discussed above.

**Steady state error**

The error gain is illustrated in Equation (31):

$$1 - ClGain_{20} = \frac{(-1 + z)(-z^{4+m} + z^{5+m} - \alpha + z^m\alpha)}{z^{4+m} - 2z^{5+m} + z^{6+m} - z^m\alpha + z^{1+m}\alpha + \rho} \tag{31}$$

Equation (31) is no longer dependent on $\rho$ in the numerator. The steady state error in response to a phase step is defined by Equation (32):

$$\lim_{z \to 1} \left( (z-1) \; \frac{\eta \, z}{z-1} \; \frac{(-1+z) \; (-z^{4+m} + z^{5+m} - \alpha + z^m \, \alpha)}{z^{4+m} - 2 \, z^{5+m} + z^{6+m} - z^m \, \alpha + z^{1+m} \alpha + \rho} \right) = 0 \tag{32}$$

The steady state error to a frequency step $\omega_0$ is Equation (33):

$$\lim_{z \to 1} \left( (z-1) \; \frac{\omega_0 \, z}{(z-1)^2} \; \frac{(-1+z) \; (-z^{4+m} + z^{5+m} - \alpha + z^m \, \alpha)}{z^{4+m} - 2 \, z^{5+m} + z^{6+m} - z^m \, \alpha + z^{1+m} \alpha + \rho} \right) = 0 \tag{33}$$

To gain an understanding of the loop operation, the loop operation in response to a frequency step is examined. Assume that the system has settled and the PLL is locked. At each clock cycle *phUpdate* must increment $\varphi vco$ by $\Delta$ = $\theta in_{n-1}$ - $\theta in_{n-2}$.

However, because the loop is locked, $\varphi err$ = 0, which implies Equation (33a):

$$\lambda_n = -\psi_{n-1} = -(\varphi vco_{n-2} - \theta vco_{n-m-2}) = -m \, \Delta \tag{33a}$$

and the integral path accumulator settles to $(1 + \alpha \, m)\Delta$.

Finally, the steady state error to a frequency ramp of slope $\frac{1}{2}$ is Equation (34):

$$\lim_{z \to 1} \left( (z-1) \; \left( \frac{A \, z \, (z+1)}{2 \, (z-1)^3} \right) \; \frac{(-1+z) \; (-z^{4+m} + z^{5+m} - \alpha + z^m \, \alpha)}{z^{4+m} - 2 \, z^{5+m} + z^{6+m} - z^m \, \alpha + z^{1+m} \alpha + \rho} \right) = A \; \frac{(1 + m \, \alpha)}{\rho} \tag{34}$$

### Steady state error in presence of delay mismatches

Delay compensation approach includes removing the phase correction due to the vco phase update of time index n-m-2 as illustrated in Equation (4) and replacing it with the correction due to the phase update of time index n-2. As a consequence of delay mismatches, the cancellation may not be complete. For example, where m is the sum of two terms, a term associated with an analog delay and a term associated with a digital delay. The first term will, in general, pose a problem because it is not a well-defined multiple of the clock period due to its dependency on process and operating conditions.

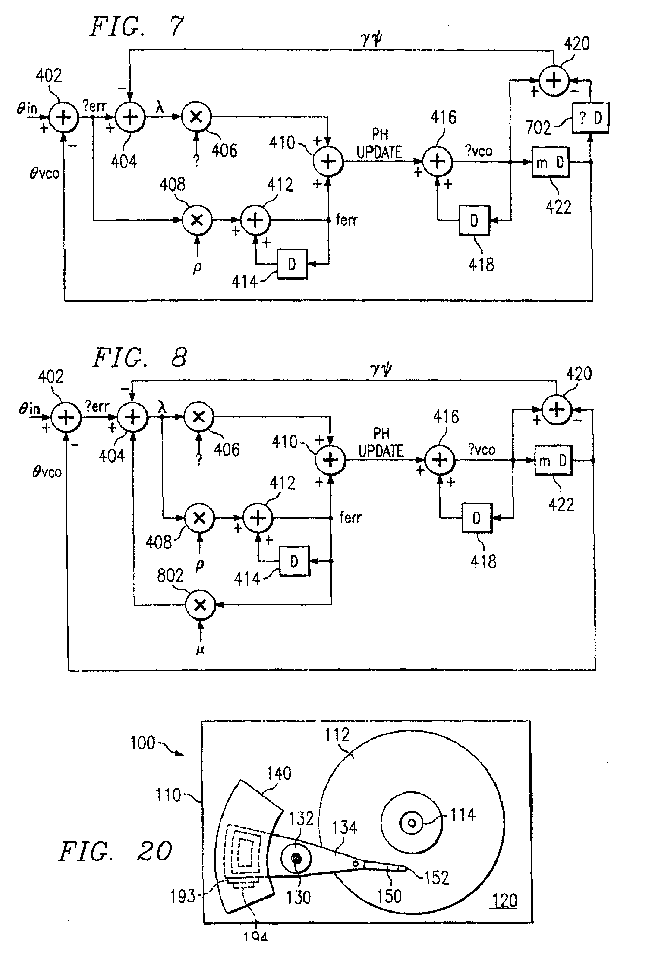

In Figure 7, the delay mismatch has been introduced through the parameter $\delta$ and Equation (27) becomes Equation (35):

$$\theta vco_n - 2 \, \theta vco_{n-1} + \theta vco_{n-2} =$$

$$\alpha \, (\, (\theta in_{n-m-5} - \theta vco_{n-m-5} - \varphi vco_{n-m-5-\delta} + \theta vco_{n-m-5-\delta} \,) - (\theta in_{n-m-6} -$$

$$\theta vco_{n-m-6} - \varphi vco_{n-m-6-\delta} + \theta vco_{n-m-6+\delta})) + \rho \, (\theta in_{n-m-6} - \theta vco_{n-m-6}) \tag{35}$$

The closed loop becomes Equation (36):

$$(z^{-m} \, (\alpha \, (z^{-5} - z^{-6}) + \rho \, z^{-6})) \, / \, (1 - 2 \, z^{-1} + z^{-2} +$$

$$\alpha \, ((z^{-m-5} + z^{-5-\delta} - z^{-m-5-\delta}) - (z^{-m-6} + z^{-6-\delta} - z^{-m-6-\delta})) + \rho \, z^{-m-6}) \tag{36}$$

Equation (36) reduces to Equation (30) when $\delta = 0$. The error gain becomes Equation (37):

$$((-1 + z) \, (-z^{4+m+\delta} + z^{5+m+\delta} - \alpha + z^m \, \alpha)) \, /$$

$$(z^{4+m+\delta} - 2 \, z^{5+m+\delta} + z^{6+m+\delta} + \alpha - z \, \alpha - z^m \, \alpha + z^{1+m} \, \alpha - z^\delta \, \alpha + z^{1+\delta} \, \alpha + z^\delta \, \rho) \tag{37}$$

The steady state error in response to a phase step is Equation (38):

$$\lim_{z \to 1} \left( (z - 1) \, \frac{\eta \, z}{z - 1} \, \frac{(-1 + z) \, (-z^{4+m+\delta} + z^{5+m+\delta} - \alpha + z^m \, \alpha)}{z^{4+m+\delta} - 2 \, z^{5+m+\delta} + z^{6+m+\delta} + \alpha - z \, \alpha - z^m \, \alpha + z^{1+m} \, \alpha - z^\delta \, \alpha + z^{1+\delta} \, \alpha + z^\delta \, \rho} \right) = 0 \tag{38}$$

while the steady state error to a frequency step $\omega_0$ is Equation (39):

$$\lim_{z \to 1} \left( (z - 1) \, \frac{\omega_0 \, z}{(z - 1)^2} \, \frac{(-1 + z) \, (-z^{4+m+\delta} + z^{5+m+\delta} - \alpha + z^m \, \alpha)}{z^{4+m+\delta} - 2 \, z^{5+m+\delta} + z^{6+m+\delta} + \alpha - z \, \alpha - z^m \, \alpha + z^{1+m} \, \alpha - z^\delta \, \alpha + z^{1+\delta} \, \alpha + z^\delta \, \rho} \right) = 0 \tag{39}$$

Finally, the steady state error to a frequency ramp of slope $\frac{A}{2}$ is Equation (40):

$$\lim_{z \to 1} \left( (z - 1) \, \left( \frac{A \, z \, (z + 1)}{2 \, (z - 1)^3} \right) \, \frac{(-1 + z) \, (-z^{4+m+\delta} + z^{5+m+\delta} - \alpha + z^m \, \alpha)}{z^{4+m+\delta} - 2 \, z^{5+m+\delta} + z^{6+m+\delta} + \alpha - z \, \alpha - z^m \, \alpha + z^{1+m} \, \alpha - z^\delta \, \alpha + z^{1+\delta} \, \alpha + z^\delta \, \rho} \right) =$$

$$A \, \frac{(1 + m \, \alpha)}{\rho} \tag{40}$$

Thus, we can conclude that the steady state system behavior is insensitive to delay compensation mismatches.

By forcing the delay compensated phase error term to zero, the scheme of Figure 4, in the presence of a frequency step, has a non zero steady state error. The concept of this second scheme lies in trying to compensate for this steady state error by feeding back an estimate of this frequency step. Such an estimate can be based on the content of the frequency accumulator, $f_{err}$, with an appropriate scaling $\mu$. A block diagram of such a system is illustrated in Figure 8 (scheme B).

In Figure 8, a multiplier 802 is added from the output of adder 412 to the summation circuit 404. To obtain an expression for the closed loop gain, Equations 41, 42 and 43 apply:

$$\psi_n = \varphi vco_{n-1} - \theta vco_{n-1} = \varphi vco_{n-1} - \varphi vco_{n-m-1} \tag{41}$$

$$\lambda_n = \varphi err_{n-1} + \ell_{n-1} - \psi_{n-1} \tag{42}$$

$$\ell_n - \ell_{n-1} = \mu \, (ferr_{n-1} - ferr_{n-2}) = \mu \, \rho \, \lambda_{n-3} \tag{43}$$

These equations, together with Equations (6) and (10), allow Equations (44), (45) and (46) in the z-domain:

$$\Psi = \Theta vco \, (z^{-1} - z^{-m-1}) = \frac{\Theta vco}{z^{-m}} \, (z^{-1} - z^{-m-1}) = \Theta vco \, (z^{m-1} - z^{-1}) \tag{44}$$

$$\mathcal{L} = \Lambda \, \mu \, \rho \, \frac{z^{-3}}{1 - z^{-1}} \tag{45}$$

$$\Theta vco = \Lambda \, z^{-m-4} \, \frac{\alpha \, (z - 1) \, + \, \rho}{1 \, - \, 2 \, z^{-1} \, + \, z^{-2}} \tag{46}$$

Combining these Equations (44), (45) and (46), we obtain Equation (47):

$$\Theta vco = z^{-m-4} \, \frac{\alpha \, (z - 1) \, + \, \rho}{1 \, - \, 2 \, z^{-1} \, + \, z^{-2}} \, (\Phi err \, z^{-1} + \mathcal{L} \, z^{-1} - \Psi \, z^{-1}) =$$
$$z^{-2} \, z^{-m-4} \, \frac{\alpha \, (z - 1) \, + \, \rho}{1 \, - \, 2 \, z^{-1} \, + \, z^{-2}} \, (\Theta in - \Theta vco) +$$
$$\Theta vco \, \mu \, \rho \, \frac{z^{-3}}{1 - z^{-1}} \, z^{-1} - z^{-m-4} \, \frac{\alpha \, (z - 1) \, + \, \rho}{1 \, - \, 2 \, z^{-1} \, + \, z^{-2}} \, \Theta vco \, (z^{m-1} - z^{-1}) \, z^{-1} \tag{47}$$

from which is obtained the closed loop gain in Equation (48):

$$ClGain_{21} = \frac{z^{-m} \, ((-1 + z) \, \alpha + \rho)}{-\alpha + \rho + z \, ((-1 + z)^2 \, z^3 + \alpha + \mu \, \rho - \mu \, z \, \rho)} \tag{48}$$

which reduces to (19) when $\mu = 0$.

**Open loop gain**

The open loop gain is shown in Equation 49.

$$OlGain_{21} = \frac{(z-1)\,\alpha+\rho}{z^m\,(-\alpha+\rho+z\,((z-1)^2\,z^3-\mu\,\rho\,z+\alpha+\mu\,\rho))-((z-1)\,\alpha+\rho)} \tag{49}$$

**Steady state error**

The error gain is shown in Equation (50):

$$1-ClGain_{21} = 1-\frac{z^{-m}\,((-1+z)\,\alpha+\rho)}{-\alpha+\rho+z\,((-1+z)^2\,z^3+\alpha+\mu\,\rho-\mu\,z\,\rho)} \tag{50}$$

The steady state error in response to a phase step is shown in Equation (51):

$$\lim_{z\to 1}\left((z-1)\,\frac{\eta\,z}{z-1}\,\left(1-\frac{z^{-m}\,((-1+z)\,\alpha+\rho)}{-\alpha+\rho+z\,((-1+z)^2\,z^3+\alpha+\mu\,\rho-\mu\,z\,\rho)}\right)\right) = 0 \tag{51}$$

while the steady state error to a frequency step is Equation (52):

$$\lim_{z\to 1}\left((z-1)\,\frac{\omega_o\,z}{(z-1)^2}\,\left(1-\frac{z^{-m}\,((-1+z)\,\alpha+\rho)}{-\alpha+\rho+z\,((-1+z)^2\,z^3+\alpha+\mu\,\rho-\mu\,z\,\rho)}\right)\right) = $$
$$(m-\mu)\,\omega_o \tag{52}$$

which vanishes for $m \equiv \mu$.

The steady state error to a frequency ramp of slope $\frac{1}{2}$ is Equation (53):

$$\lim_{z\to 1}\left((z-1)\,\left(\frac{A\,z\,(z+1)}{2\,(z-1)^3}\right)\,\left(1-\frac{z^{-m}\,((-1+z)\,\alpha+\rho)}{-\alpha+\rho+z\,((-1+z)^2\,z^3+\alpha+\mu\,\rho-\mu\,z\,\rho)}\right)\right) = $$
$$\frac{A\,(-2-2\,m\,\alpha+3\,m\,\rho+m^2\,\rho)}{2\,\rho} - \frac{A\,m\,(3+m)}{2} - \frac{A\,(1+m\,\alpha)}{\rho} \tag{53}$$

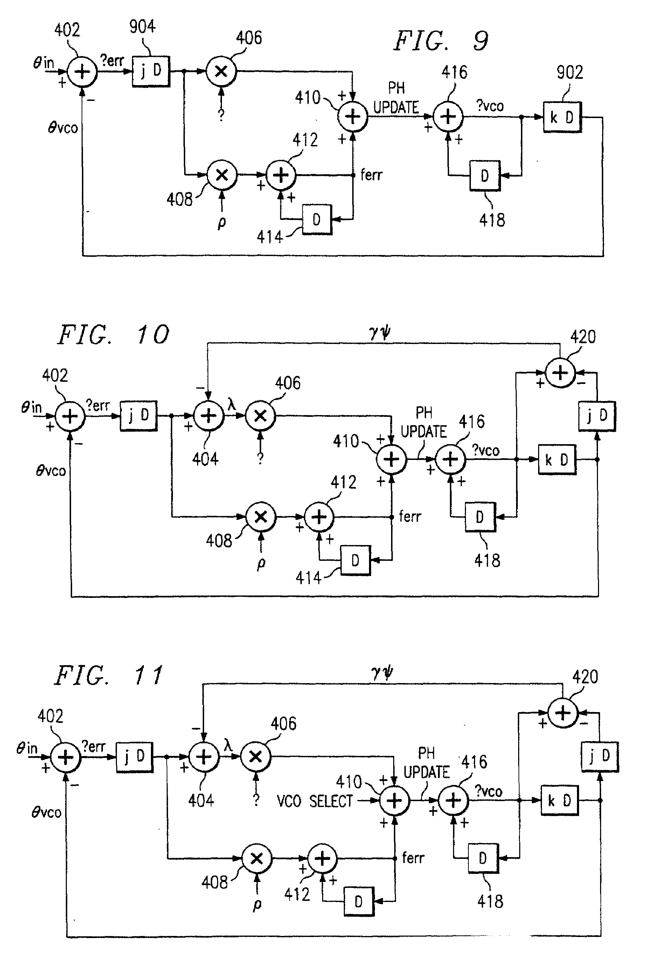

Figure 9 shows a modified version of the block diagram in Figure 1. Figure 9 illustrates a split latency m in two terms j and k, delay backs 902 and 904. The first one, delay back 904, represents the delay from the time the input signal is sampled to the time the corresponding phase error is computed and outputted from the phase detector. The second term k, delay back 902, represents the time that elapses between a Vco phase update and the time the sampling position moves accordingly.

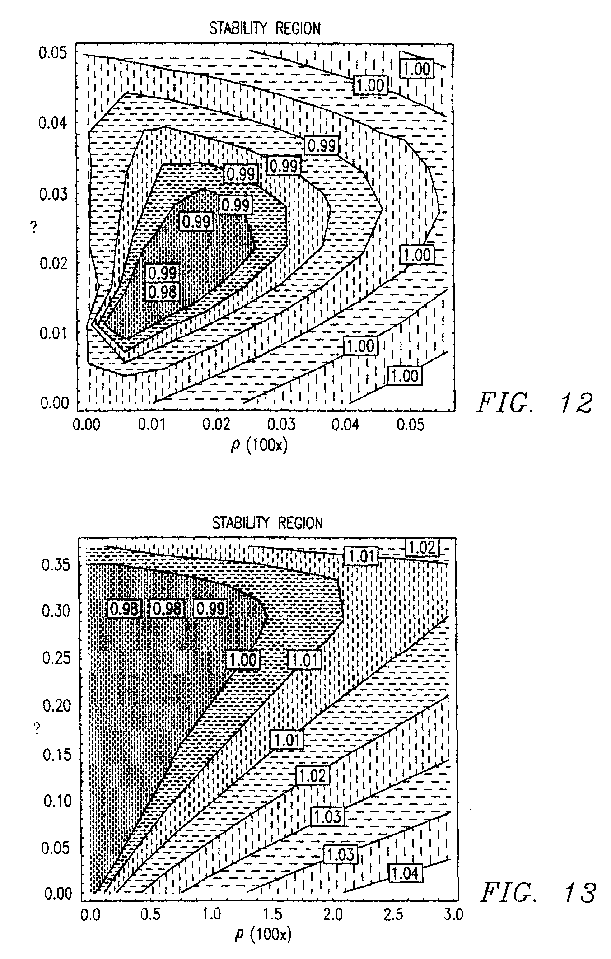

Figure 10 shows the corresponding delay compensated version (scheme A). In this case, the closed loop transfer function is given by Equation (19) with m = j = k and that, as a consequence, the results derived for scheme A apply to Figure 12.

By inspection, we can obtain Equations (54), (55) and (56):

$$\Theta\text{vco}_n = \varphi\text{vco}_{n-k} \tag{54}$$

$$\Theta\text{vco}_n = \Theta\text{vco}_{n-1} + \text{pbUpdate}_{n-k-1} \tag{55}$$

$$\lambda_n = \varphi\text{err}_{n-j-1} - \gamma\psi_{n-1} = (\theta\text{in}_{n-j-2} - \theta\text{vco}_{n-j-2}) - \gamma (\varphi\text{vco}_{n-2} - \varphi\text{vco}_{n-j-k-2}) =$$

$$(\theta\text{in}_{n-j-2} - \gamma \varphi\text{vco}_{n-2}) - \theta\text{vco}_{n-j-2} (1 - \gamma) \tag{56}$$

Equation (48) is similar to Equation (8) except for an index change. Consequently, Equation (57) is illustrated:

$$\theta\text{vco}_n - 2 \theta\text{vco}_{n-1} + \theta\text{vco}_{n-2} = \alpha ( \lambda_{n-k-3} - \lambda_{n-k-4}) + \rho \lambda_{n-k-4} \tag{57}$$

Using the new definition for $\lambda$ given in Equation (49), we have Equation (58):

$$\rho ((\theta\text{in}_{n-j-k-6} - \gamma \varphi\text{vco}_{n-k-6}) - \theta\text{vco}_{n-j-k-6} (1 - \gamma)) =$$
$$\alpha ((\theta\text{in}_{n-j-k-5} - \gamma \theta\text{vco}_{n-5}) - \theta\text{vco}_{n-j-k-5} (1 - \gamma) - (\theta\text{in}_{n-j-k-6} - \gamma \theta\text{vco}_{n-6}) +$$
$$\theta\text{vco}_{n-j-k-6} (1 - \gamma)) + \rho ((\theta\text{in}_{n-j-k-6} - \gamma \theta\text{vco}_{n-6}) - \theta\text{vco}_{n-j-k-6} (1 - \gamma)) =$$
$$\alpha((\theta in_{n-j-k-5} - \gamma\theta vco_{n-5}) - \theta vco_{n-j-k-5}(1-\gamma) - (\theta in_{n-j-k-6} - \gamma\theta vco_{n-6}) +$$
$$\theta vco_{n-j-k-6}(1-\gamma)) + \rho((\theta in_{n-j-k-6} - \gamma\theta vco_{n-6}) - \theta vco_{n-j-k-6}(1-\gamma)) \tag{58}$$

For $\gamma = 0$, which is for the uncompensated case, Equation (51) reduces to Equation (59):

$$\theta\text{vco}_n - 2 \theta\text{vco}_{n-1} + \theta\text{vco}_{n-2} =$$

$$\alpha ((\theta\text{in}_{n-j-k-5} - \theta\text{vco}_{n-j-k-5}) - (\theta\text{in}_{n-j-k-6} - \theta\text{vco}_{n-j-k-6})) +$$

$$\rho (\theta\text{in}_{n-j-k-6} - \theta\text{vco}_{n-j-k-6}) \tag{59}$$

which is identical to Equation (14) for $j + k = m$. For $\gamma = 0$, which is for the compensated case (scheme A), Equation (51) reduces to Equation (60):

$$\theta\text{vco}_n - 2 \theta\text{vco}_{n-1} + \theta\text{vco}_{n-2} =$$

$$\alpha ((\theta\text{in}_{n-j-k-5} - \theta\text{vco}_{n-5}) - (\theta\text{in}_{n-j-k-6} - \theta\text{vco}_{n-6})) + \rho (\theta\text{in}_{n-j-k-6} - \theta\text{vco}_{n-6}) \tag{60}$$

Likewise, it can be demonstrated that the topology of Figure 11 is equivalent to the one presented in Figure 8 (scheme B).

The advantages associated with decoupling the PLL behavior from the loop latency can be summarized as follows. First, it is possible to introduce pipelining in the design of the sampling network (e.g. ADC) equalization circuits (e.g. finite impulse response filters) and decision directed phase detector of the read channel. This will ease the design of these critical components without degrading the performance of the PLL.

An embodiment of the present invention increases the system stability region. Because the stability region is significantly larger than in the uncompensated case, the tracking optimization is improved.

Figure 12 shows the stability region for an uncompensated system with m = 10. This contour plot has been generated by compiling, for a given $\alpha$ and $\rho$, the poles of Equation (16) and reporting the magnitude of the pole further from the origin. Clearly, those settings for which such value is $\leq 1$ will correspond to stable operating points. For the purpose of this analysis, the ranges of the loop parameters $\rho$ (x-axis) and $\alpha$ (y-axis) have been adjusted to maximize the operating region, which is the region in which the system is stable.

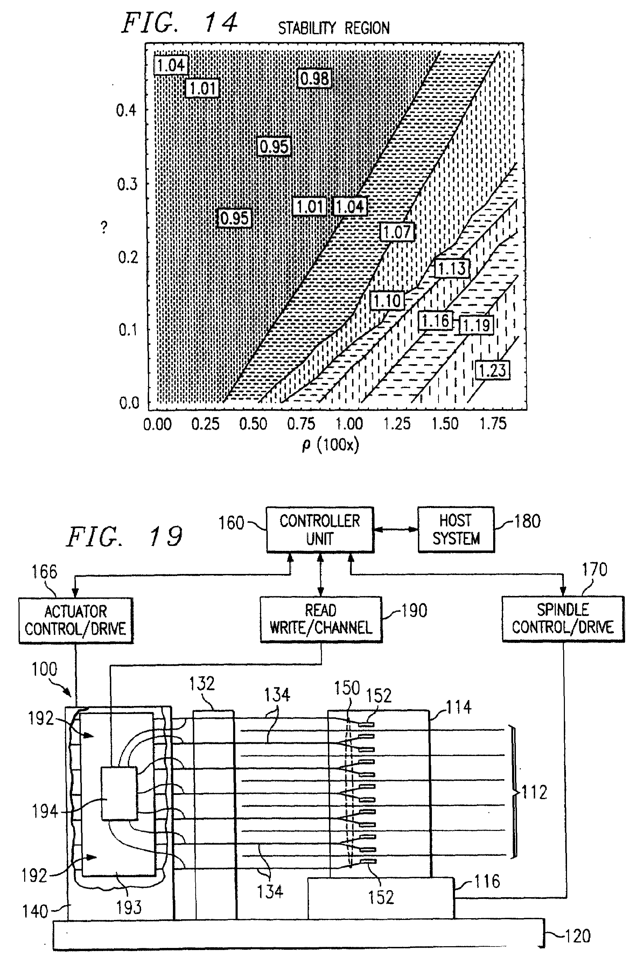

Figures 13 and 14 show the stability region when using the topologies presented in Figures 6 and 7. When compared to Figure 12, it can be concluded that the stability region has increased by a factor of 20.

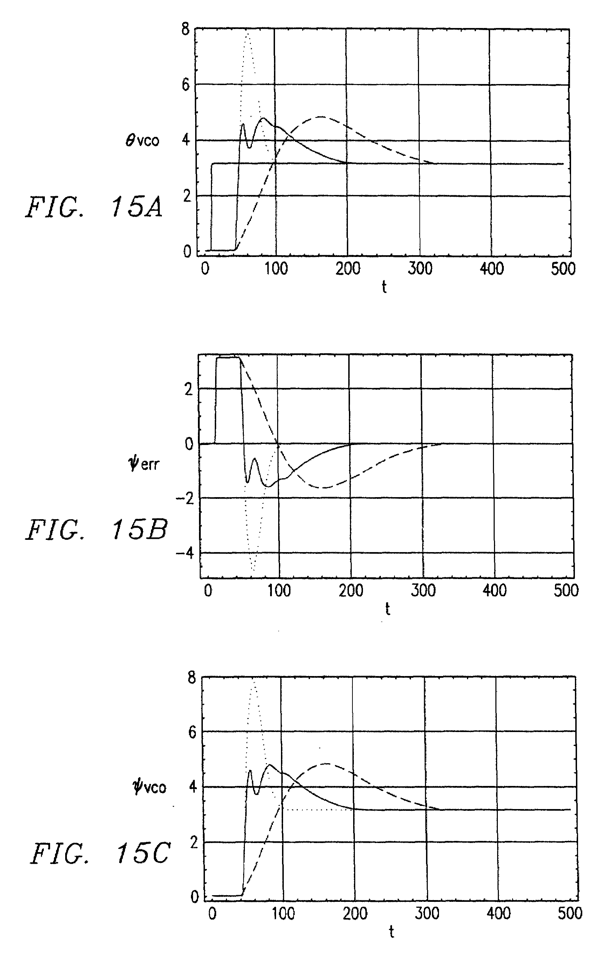

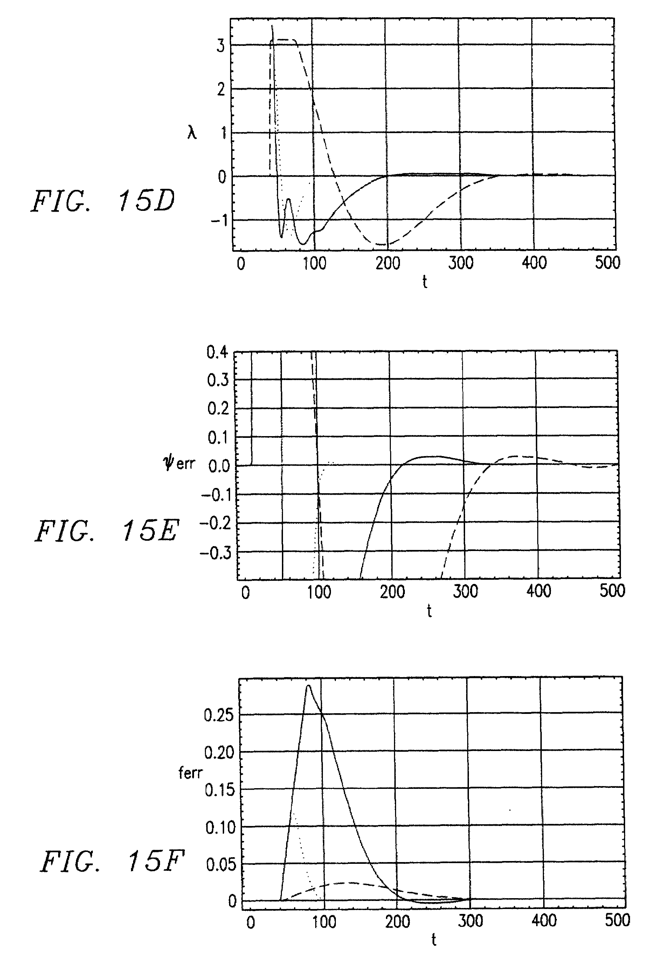

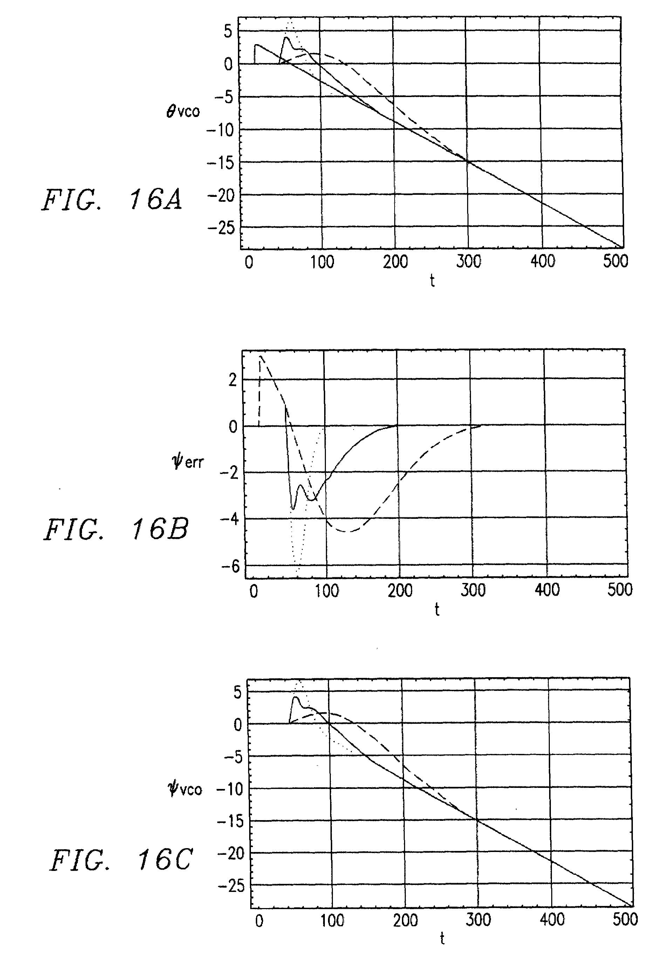

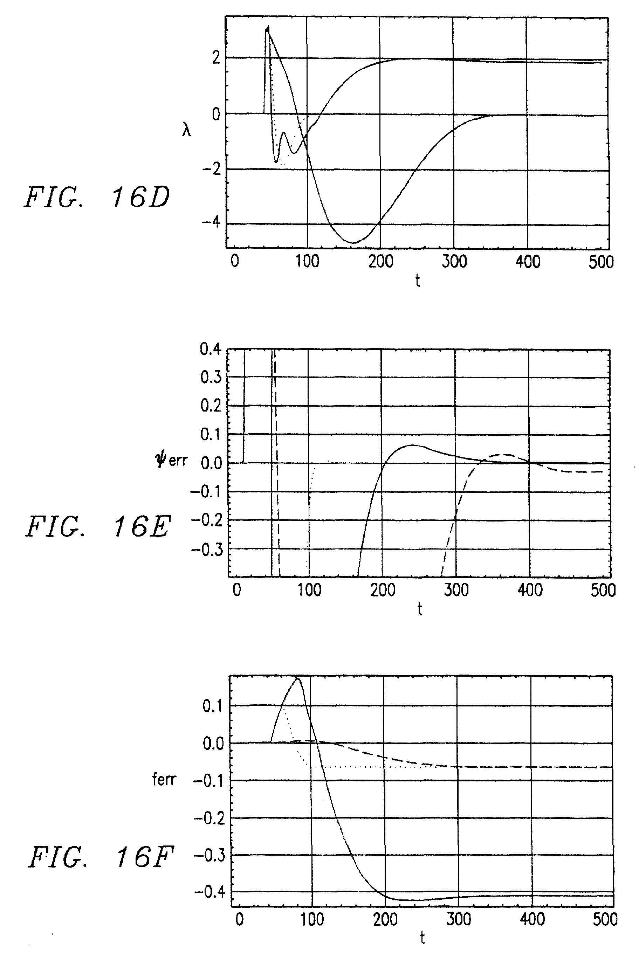

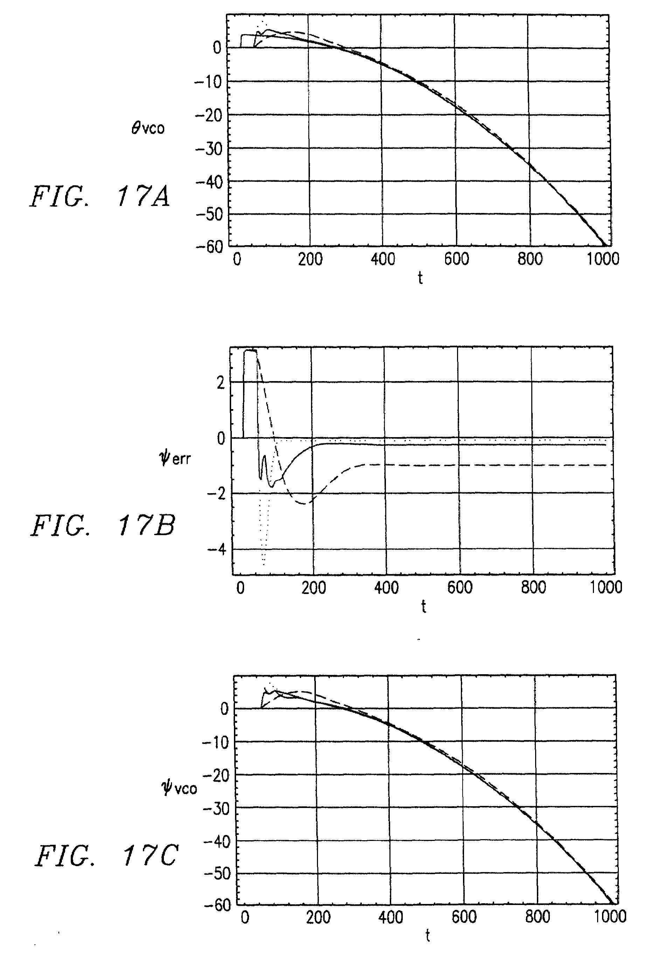

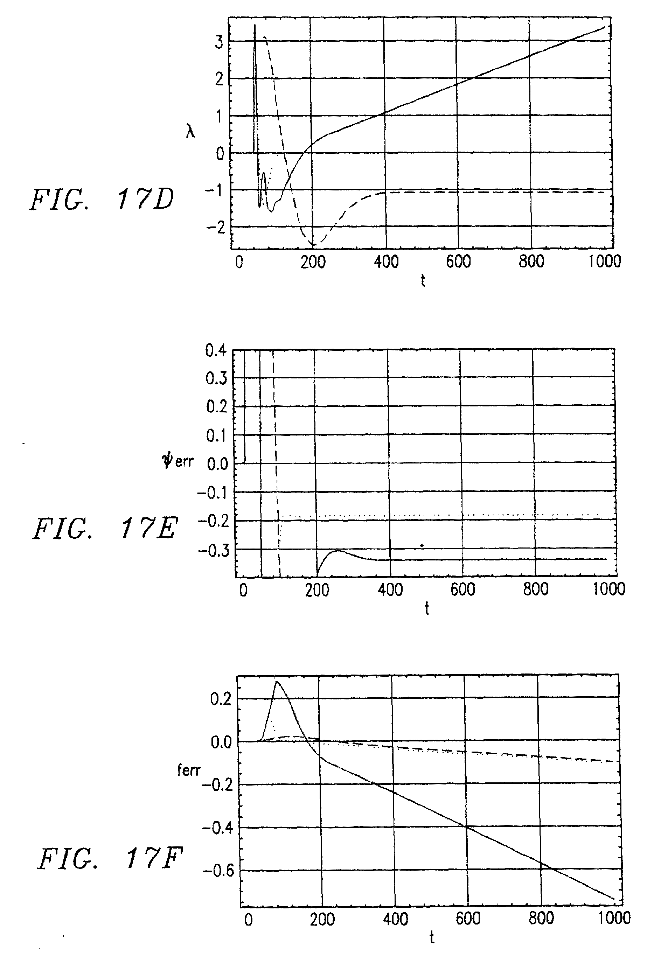

The dynamic characteristics of the system are greatly improved with respect to the uncompensated case. In particular, the residual steady state error in response to a frequency ramp is largely reduced because the system effective delay has been greatly reduced. Figures 15-17 show a comparison of the dynamics of the system to a phase step, a 1% frequency step and a frequency ramp, respectively. As in the previous case, the simulations were performed assuming m = 30.

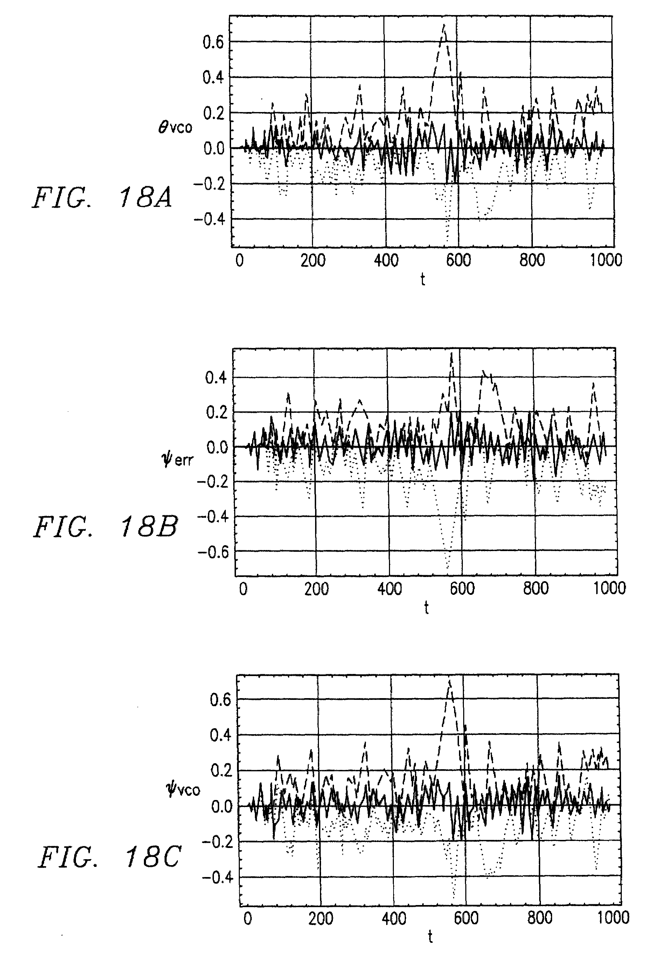

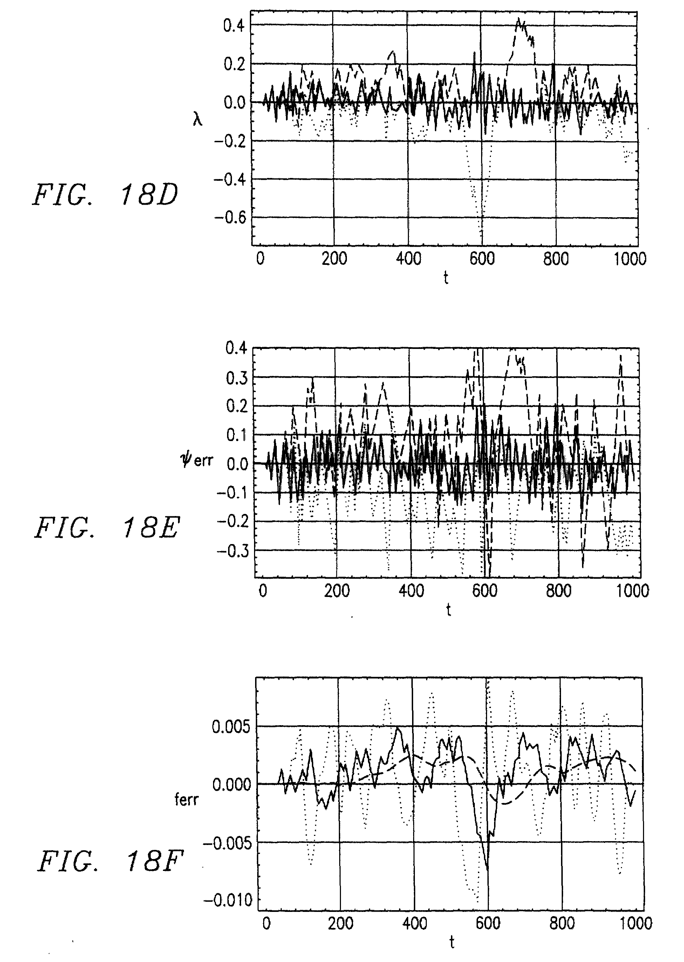

The loop bandwidth is no longer limited by the loop latency and can be optimized on the basis of input noise and reference clock noise characteristics. In particular, in situations where the reference clock is noisy, the compensated topology presents a clear advantage, as illustrated in Figure 18. One can observe that the latency, by which the control action in response to noise on the reference clock is limited, is effectively canceled or significantly reduced by the compensated topology.

In view of the foregoing description it will be evident to a person skilled in the art that various modifications may be made within the scope of the invention.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

**Claims**

1. A phase locked loop circuit for reducing loop latency, comprising:

   an input circuit for inputting a phase signal corresponding to phase changes and an actual phase signal corresponding to actual phase sampling of a sampling clock;
   a filter circuit for connecting said phase signal and said actual phase signal to a phase update signal; and
   a feedback circuit to reduce said loop latency by feeding back to said filter circuit a portion of said phase update signal.

2. A phase locked loop circuit according to claim 1, for eliminating loop latency, wherein said feedback circuit is configured to eliminate said loop latency.

FIG. 1

FIG. 2

FIG. 3

FIG. 4

FIG. 5

FIG. 6

**FIG. 7**

**FIG. 8**

**FIG. 20**

FIG. 9

FIG. 10

FIG. 11

STABILITY REGION

FIG. 12

STABILITY REGION

FIG. 13

*FIG. 14* STABILITY REGION

*FIG. 19*

*FIG. 15A*

$\theta$vco

*FIG. 15B*

$\psi$err

*FIG. 15C*

$\psi$vco

FIG. 15D

FIG. 15E

FIG. 15F

FIG. 16A

$\theta$vco

FIG. 16B

$\psi$err

FIG. 16C

$\psi$vco

FIG. 16D

FIG. 16E

FIG. 16F

FIG. 17A

FIG. 17B

FIG. 17C

FIG. 17D

FIG. 17E

FIG. 17F

FIG. 18A

FIG. 18B

FIG. 18C

FIG. 18D

FIG. 18E

FIG. 18F